# EUROPÄISCHE PATENTSCHRIFT

(11) **EP 3 429 325 B1**
(45) Veröffentlichungstag und Bekanntmachung des Hinweises auf die Patenterteilung: **14.09.2022**
(21) Anmeldenummer: 18183169.4
(22) Anmeldetag: 12.07.2018
(51) Int. Cl.: H05K 7/14, H05K 7/20

(54) **TEMPERIERBARES MODUL FÜR EIN RECHENZENTRUM, RECHENZENTRUM UND VERFAHREN ZUR TEMPERIERUNG EINES RECHENZENTRUMS**
TEMPERATURE-CONTROLLABLE MODULE FOR A COMPUTER CENTRE, COMPUTER CENTRE AND METHOD FOR THE TEMPERATURE CONTROL OF A COMPUTER CENTRE
MODULE POUVANT ÊTRE MIS EN TEMPÉRATURE POUR UN CENTRE DE CALCUL, CENTRE DE CALCUL ET PROCÉDÉ DE MISE EN TEMPÉRATURE D'UN CENTRE DE CALCUL

(30) Priorität: 12.07.2017 DE 102017115693
(43) Veröffentlichungstag der Anmeldung: 16.01.2019
(73) Patentinhaber: CoinBau GmbH, 01097 Dresden (DE)
(72) Erfinder: Krause, Sebastian, 01097 Dresden (DE)
(74) Vertreter: Riechelmann & Carlsohn Patentanwälte PartG mbB

(56) Entgegenhaltungen:
- EP-A1- 2 673 683
- US-A1- 2016 007 506
- US-B1- 7 800 900

## Beschreibung

Die Erfindung betrifft ein temperierbares Modul für ein Rechenzentrum, ein Rechenzentrum, das ein oder mehrere solche Module aufweist, sowie ein Verfahren zur Temperierung des oder der Module eines Rechenzentrums.

Das computergestützte Rechnen, insbesondere das Hochleistungsrechnen (engl.: high-performance computing (HPC)), erfordert leistungsfähige Rechentechnik. Diese Rechentechnik umfasst typischerweise mehrere Server, die zum Betrieb erforderliche Infrastruktur sowie Netzwerkeinrichtungen, die die Kommunikation mit den Servern ermöglichen sollen. Ein Rechenzentrum weist in der Regel einen oder mehrere Räume auf, in denen jeweils ein oder mehrere Racks angeordnet sind, die die Server aufnehmen. Dabei kann ein Rack die Server in mehreren, übereinander liegenden Reihen aufnehmen. Die in dem Rack angeordneten Server werden über die Infrastruktur mit elektrischem Strom und Kommunikationsverbindungen zum Netzwerk versorgt. Der Einsatz dieser Rechentechnik erfordert in der Regel eine Klimatisierung der Rechentechnik in dem Rechenzentrum. Einerseits ist der Betrieb der Server mit der Entwicklung von Wärme verbunden, andererseits erfordert der Betrieb der Server eine Raumtemperatur, die einen unteren Grenzwert nicht unterschreiten und einen oberen Grenzwert nicht übersteigen darf. Weiterhin bedürfen Standardserver einer bestimmten Luftreinheit, um das Anlagern von Partikeln und eine damit verbundene Performanceeinbuße zu verhindern.

DE 20 2013 100 519 U1 sieht ein Modul für ein Rechenzentrum mit einem Doppelboden vor, in dem ein Lüfter und ein Wärmetauscher angeordnet sind. Mittels des Lüfters soll erwärmte Luft aus dem Serverraum über den Doppelboden abgezogen werden. Die erwärmte Luft soll dabei in den Doppelboden gelangen, am Wärmetauscher abgekühlt und anschließend als abgekühlte Luft in den Serverraum zurückgeführt werden. Die in DE 20 2013 100 519 U1 vorgeschlagene Klimatisierungseinrichtung soll allerdings nur eine Kühlung der Luft ermöglichen, eine Erwärmung der Luft ist nicht vorgesehen. Wird ein solches Rechenzentrum jedoch in geografischen Bereichen aufgestellt, die eine vergleichsweise geringe Außentemperatur aufweisen, ist die in DE 20 2013 100 519 U1 vorgeschlagene Kühlung entweder nicht erforderlich, weil die Umgebungstemperaturen so niedrig sind, dass die zum Betrieb der Server erforderliche untere Grenze nicht überschritten wird, oder energetisch ungünstig, weil eine Kühlung der erwärmten Luft mittels eines Wärmeaustauschers mit einem hohen Energieverbrauch verbunden ist. Derartige geographische Bereiche können beispielsweise einen Breitengrad größer 60° nördlicher oder südliche Bereite aufweisen oder sich in Höhenlagen, beispielsweise in alpinen Bereichen befinden. Beispiele derartiger geographischer Bereiche befinden in Island, Norwegen, Österreich und Schweden.

Die Integrationsdichte bisher bekannter Rechenzentren im T1-Bereich ist gering und insbesondere nicht auf T1-Applikationen ausgelegt. Eine energetisch sinnvolle Kühlung von hochintegrierter Hardware zum Hochleistungsrechnen, beispielsweise zur Erbringung des Proof-of-Work bei der Blockchain-Verifikation, ist mit den Methoden des Standes der Technik nicht erreichbar. Unter "T1" wird eine Datenübertragungsgeschwindigkeit von 1,544 Mbit/s verstanden.

Aus GB 2 474 944 A1 ist ein Datenzentrum bekannt, dass eine Halle und ein Klimakontrollsystem aufweist. Das Klimakontrollsystem besitzt einen Einlasskanal, der eine Auslassöffnung an der Innenseite einer Halle aufweist, in der sich ein Datenzentrum befindet, allerdings nicht in den Raum des Datenzentrums, in dem sich die Racks befinden. Das System besitzt ferner einen Auslasskanal, der eine Auslassöffnung an der Innenseite der Halle aufweist.

Aus US 2016/0007506 A1 ist ein modulares Datenzentrum bekannt. Das Datenzentrum erfordert den Einsatz von Lüftern, die einer Lüftereinheit angeordnet sind. Aus EP 2 673 683 A0 ist ein modulares Datenzentrum mit einem System zur Führung von Luft bekannt. Das System erfordert den Einsatz eines Ventilators. Auch das aus US 7.800.900 B1 bekannte System erfordert einen Lüfter zur Kühlung einer Serverfarm

Aufgabe der Erfindung ist es, die Nachteile nach dem Stand der Technik zu beseitigen. Es soll insbesondere ein temperierbares Modul für ein Rechenzentrum angegeben werden, das keine zusätzlichen Kühleinrichtungen, insbesondere Wärmetauscher erfordert. Es sollen ferner ein Rechenzentrum, das ein oder mehrere solche Module aufweist, sowie ein Verfahren zur Temperierung des oder der Module eines Rechenzentrums angegeben werden.

Diese Aufgabe wird durch die Merkmale der Ansprüche 1, 9 und 11 gelöst. Zweckmäßige Ausgestaltungen der Erfindungen ergeben sich aus den Merkmalen der Unteransprüche.

Nach Maßgabe der Erfindung ist ein Modul für ein Rechenzentrum vorgesehen, das einen temperierbaren Innenraum und einen Luftleitraum aufweist. In dem Innenraum ist ein Rack angeordnet, das einen ersten Raumbereich von einem zweiten Raumbereich trennt. Der Luftleitraum weist eine erste Kammer und eine zweite Kammer auf, wobei
- erste Luftdurchtrittsöffnungen einen Luftdurchtritt zwischen dem ersten Raumbereich und der ersten Kammer und zwischen dem zweiten Raumbereich und der zweiten Kammer ermöglichen,
- zweite, verschließbare Luftdurchtrittsöffnungen im geöffneten Zustand einen Luftdurchtritt zwischen der ersten Kammer und der zweiten Kammer ermöglichen,
- dritte, verschließbare Luftdurchtrittsöffnungen im geöffneten Zustand einen Luftdurchtritt zwischen der ersten Kammer und der Umgebung ermöglichen, und
- vierte, verschließbare Luftdurchtrittsöffnungen im geöffneten Zustand einen Luftdurchtritt zwischen der zweiten Kammer und der Umgebung ermöglichen.

Das Modul weist eine Wandung auf, die den Innenraum von dem Luftleitraum trennt. Bei der Wandung handelt es sich um den Boden oder die Decke des Innenraumes. In der Wandung sind die ersten Luftdurchtrittsöffnungen ausgebildet. Der Luftleitraum weist eine Trennwand auf, die den Luftleitraum in eine erste Kammer und eine zweite Kammer teilt. In der Trennwand sind die zweiten, verschließbaren Luftdurchtrittsöffnungen ausgebildet. Die dritten, verschließbaren Luftdurchtrittsöffnungen sind in einer Außenwand der ersten Kammer ausgebildet. Die vierten, verschließbaren Luftdurchtrittsöffnungen sind in einer Außenwand der zweiten Kammer ausgebildet. Der Innenraum ist von einem Container gebildet, wobei der Container eine Wandung aufweist, an der der Luftleitraum angebracht ist, wobei in der Wandung des Containers zumindest im Bereich des ersten Raumbereiches und des zweiten Raumbereiches die ersten Luftdurchtrittsöffnungen ausgebildet sind.

Unter Temperierung wird insbesondere das Einstellen der Temperatur in dem Innenraum durch Kühlen oder Erwärmen verstanden. Das erfindungsgemäße Modul kann ein mobiles Modul sein.

Die ersten, zweiten, dritten und vierten Luftdurchtrittsöffnungen ermöglichen die Temperierung des Innenraumes des Moduls mittels Umgebungsluft, ohne dass zusätzliche Kühleinrichtungen, beispielsweise ein Wärmetauscher erforderlich sind. Das erfindungsgemäße Modul kann vorteilhaftweise in geographischen Bereichen eingesetzt werden, deren durchschnittliche Jahreshöchsttemperatur 25 °C nicht übersteigen.

Das Rack trennt den Innenraum in einen ersten Raumbereich und einen zweiten Raumbereich. Der erste Raumbereich ist somit von dem Rack begrenzt. Er kann ferner von Wandungen des Innenraumes begrenzt sein. Der zweite Raumbereich ist ebenso von dem Rack begrenzt. Er kann ferner von Wandungen des Innenraumes begrenzt sein. Das erste Raumbereich wird im Folgenden als Kaltgang bezeichnet, weil ihm Zuluft aus der Umgebung über die erste Kammer des Luftleitraums zugeführt werden kann. Der zweite Raumbereich wird im Folgenden als Warmgang bezeichnet, weil aus ihm Abluft in die Umgebung über die zweite Kammer des Luftleitraums abgeführt werden kann. Die Zuluft sollte dabei kälter als die Abluft sein.

Der Innenraum des erfindungsgemäßen Moduls wird vorzugsweise von einem ISO-Container gebildet. An einer Wandung des Containers, vorzugsweise dem Boden oder der Decke des Containers, ist der Luftleitraum angebracht. Die Wandung des Containers, an der der Luftleitraum ausgebildet ist, ist die Wandung, in der die ersten Luftdurchtrittsöffnungen ausgebildet sind. Der Container kann ein ISO-Container sein. Bei dem ISO-Container kann es sich beispielsweise um einen 40-Fuß-ISO-Container oder 20-Fuß-ISO-Container handeln. Nach ISO-Norm 668: 2013-08 mit den Änderungen AMD 1 und 2: 2016-03 weist ein 40-Fuß-ISO-Container eine Außenlänge von 12,192 m, eine Außenbreite von 2,438 m und eine Außenhöhe von 2,591 m auf, ein 20-Fuß-ISO-Container eine Außenlänge von 6,058 m, eine Außenbreite von 2,438 m und eine Außenhöhe von 2,591 m auf. In einer Wandung des Containers, vorzugsweise im Boden oder der Decke des Containers, können zumindest im Bereich des Kaltganges und des Warmganges die ersten Luftdurchtrittsöffnungen ausgebildet sein. Dazu können beispielsweise die Platten, die standardgemaß den Boden des Containers bilden, entfernt werden, wodurch die ersten Luftdurchtrittsöffnungen entstehen. Die entfernten Platten können aber auch durch Bauelemente, die die ersten Luftdurchtrittsöffnungen aufweisen, beispielsweise Trittgitterroste, ersetzt werden, was für die Nutzung des erfindungsgemäßen Moduls aber nicht erforderlich ist. Die Bauelemente ermöglichen jedoch ein Begehen des Containers. Im Eingangsbereich des Containers kann ein Riffelblech mit einem Höhenausgleich anstelle des ursprünglichen Bodens vorgesehen sein. Als Eingang in den Container können die standardmäßig vorgesehen Containertüren dienen. Die Türen werden zweckmäßigerweise gegen unbefugten Zutritt geschützt. Vorzugsweise ist eine Vorrichtung zum Schutz gegen Windeinwirkungen vorgesehen, die im geöffneten Zustand des Containers dessen Innenraum vor Windeinwirkungen schützt.

Es kann vorgesehen sein, dass der Container vom Untergrund, auf dem das erfindungsgemäße Modul steht, beabstandet ist. Dazu kann der Container erhöht angeordnet, beispielsweise aufgeständert sein. Das ist besonders zweckmäßig, wenn sich die Luftleitkammer am Boden des Containers befindet. Zweckmäßigerweise ist der Luftleitraum ebenfalls vom Untergrund beabstandet, wenn er am Boden des Containers ausgebildet ist. Damit wird zwischen der Außenseite des Luftleitraums, die dem Untergrund zugewandt ist, und dem Untergrund ein Abstand erhalten, der eine Luftbewegung unter dem Modul erlaubt. Auf diese Weise kann ein Aus- oder Eintritt von Luft in die erste und/oder zweite Kammer erleichtert werden. Außerdem wird die Anlagerung von Laube, Schnee etc. verhindert. Der Abstand zwischen der Außenseite des Luftleitraums, die dem Untergrund zugewandt ist, und dem Untergrund kann beispielsweise 20 cm oder mehr, vorzugsweise 30 cm betragen. Zum Aufständern des Containers können Stützen vorgesehen sein. Diese Stützen sind zweckmäßigerweise an den unteren vier Ecken, bevorzugt an den Eckbeschlägen des Containers befestigt. Um ein Einsinken der Stützen am Aufstellort des erfindungsgemäßen Moduls zu verhindern, können an den Enden der Stützen, die dem Boden des Container abgewandt sind, Abstützplatten angebracht sein. Vorzugsweise sind vier Stützen vorgesehen. Die Eckbeschläge eines ISO-Containers werden in der ISO-Norm 1161: 2016-07 beschrieben. Vorzugsweise befindet sich die Unterseite des ISO-Containers in einer Höhe von 80 bis 150 cm, vorzugsweise in einer Höhe von 100 cm. Um die Zugänglichkeit des ISO-Containers zu gewährleisten, kann ein Treppenpodest, vorzugsweise ein Treppenpodest mit Geländer vorgesehen sein. Das Treppenpodest wird zweckmäßigerweise an der Vorderseite des Containers, an der sich die Containertüren befinden, montiert. An dem Treppenpodest können Sicherungsmittel zum Sichern der Containertüren, insbesondere der äußeren Containertüren vorgesehen sein.

Der Innenraum des Containers bildet den Innenraum des Moduls. In dem Innenraum ist das erfindungsgemäß vorgesehene Rack angeordnet. Das Rack trennt den Innenraum in den als Kaltgang bezeichneten ersten Raumbereich und den als Warmgang bezeichneten zweiten Raumbereich. Das Rack erstreckt sich dazu vorzugsweise vom Boden des Innenraums bis zu dessen Decke. Vorzugsweise ist das Rack mittig, bezogen auf die Breite des Innenraum angeordnet. Es kann vorgesehen sein, dass der Kaltgang und der Warmgang die gleiche Breite haben. Das Rack kann aus einem oder mehreren Rahmen, beispielsweise einem oder mehreren Schweißrahmen, in Verbindung mit eingebauten Blechen hergestellt sein. Am Boden des Containers kann der oder die Rahmen fest mit dem Container verbunden sein, beispielsweise mittels einer Schweißverbindung wie einer Schweißnaht. Die Verbindung des Racks mit dem Boden kann zur Fundamentierung und zum Ausgleich von Fertigungstoleranzen über ein Profilrahmen erfolgen, der am Boden oder Längs- und/oder Querträgern des Containers befestigt ist und auf dem der oder die Rahmen des Racks aufsitzen. Ebenso können der oder die Rahmen an der Decke des Containers fest mit dem Container verbunden sein, beispielsweise mittels einer Schweißverbindung wie einer Schweißnaht. Die Verbindung des oder der Rahmen mit dem Boden und der Decke bietet eine zusätzliche Steifigkeit. Die Verbindung des oder der Rahmen mit dem Boden und der Decke trägt zur wirksamen Trennung zwischen dem Kaltgang und dem Warmgang bei.

Ist das Rack mittig, bezogen auf die Breite des Innenraumes angeordnet, so kann sich der Kaltgang zwischen einer Seitenwand des Containers und dem Rack und der Warmgang zwischen der anderen Seitenwand des Containers und dem Rack befinden. Der Kaltgang wird dann von dem Rack und einer Seitenwand des Containers begrenzt, während der Warmgang von dem Rack und der anderen Seitenwand des Containers begrenzt wird. Die beiden Seitenwände des Containers können einander gegenüber liegen und die Rückseite des Containers mit dessen Vorderseite verbinden.

Es kann vorgesehen sein, dass sich das Rack von der Rückseite des Containers in der Richtung der Vorderseite des Containers, in der die Containertüren ausgebildet sind, erstreckt. Dabei kann vorgesehen sein, dass das Rack mit der Rückwand des Containers fest verbunden ist, beispielsweise mittels einer Schweißverbindung wie einer Schweißnaht. Das Rack kann sich bis zur Vorderseite des Containers erstrecken. Alternativ und bevorzugt ist an der Vorderseite des Containers ein Schaltschrank ausgebildet, der ebenfalls mittig, bezogen auf die Breite des Innenraumes, auf dem Boden angeordnet ist. Der Schaltschrank erstreckt sich vorteilhafterweise vom Boden bis zur Decke des Innenraums und kann am Boden und an der Decke befestigt sein. Er weist vorzugsweise die gleiche Breite wie das Rack auf und ist fluchtend zum Rack angeordnet. Ist ein Schaltschrank vorgesehen, so erstreckt sich das Rack bis zum Schaltschrank, wobei das Rack zumindest annähernd strömungsdicht an den Schaltschrank angrenzt.

Das Rack ist ein Regal, das zur Aufnahme elektronischer Komponenten, insbesondere von Computern wie Servern, dient. Die elektronischen Komponenten können jeweils zumindest einen Lüfter enthalten, der eine Kühlung der jeweiligen Komponente bewirken soll. Die Erfindung beruht auf der Erkenntnis, dass die in den Servern enthaltenen Lüfter ausreichend sind, um eine ausreichende Belüftung des Innenraumes sicherzustellen. Insbesondere können die Lüfter (i) eine Führung eines Luftstromes im geschlossenen Kreislauf zwischen dem Innenraum und dem Luftleitraum, (ii) eine Ansaugung von Außenluft über eine Kammer des Luftleitraums und die Abgabe von Luft an die Umgebung über eine andere Kammer des Luftleitraums und (iii) die Mischung von Außenluft mit Luft, die im Kreislauf geführt wird, bewirken. In einer Ausführungsform der Erfindung kann das Rack beispielsweise 200 oder mehr Server aufnehmen. Zusätzlich kann es Switche aufnehmen. Die elektronischen Komponenten können beispielsweise jeweils eine Höhe von vier Höheneinheiten (HE) aufweisen. Die elektronischen Komponenten können an dem Rack befestigt sein. Beispielweise können die elektronischen Komponenten Montagewinkel aufweisen, die mittels Käfigmuttern mit dem Rack verschraubt sind. Um den Durchtritt von Luft zwischen den Kaltgang und dem Warmgang, abgesehen von der Luft, die von den Lüftern der elektronischen Komponenten durch die elektronischen Komponenten selbst von Kaltgang zum Warmgang befördert wird, zu verhindern, sollte das Rack vollständig oder zumindest weitestgehend strömungsdicht abgeschlossen sein. Dazu sollten Plätze in dem Rack, die keine elektronische Komponente aufgenommen haben, verschlossen werden, beispielsweise mittels Platten.

Bei den elektronischen Komponenten kann es sich insbesondere um Computer wie Server handeln. Die elektronischen Komponenten sollten jeweils zumindest einen Lüfter aufweisen. Vorzugsweise weist jede elektronische Komponente zumindest zwei Lüfter auf. Bei dem Lüfter handelt es sich vorzugsweise um einen Ventilator. Es kann vorgesehen sein, dass die Lüfter unabhängig von den übrigen Bestandteilen der elektronischen Komponente gestartet werden können. Das bedeutet, dass die Lüfter in Betrieb genommen werden können, bevor die elektronischen Komponenten insgesamt in Betrieb genommen werden. Dazu können die elektronischen Komponenten eine Firmware aufweisen, die den Start der Lüfter unabhängig vom Start der elektronischen Komponenten bewirken kann. Die elektronischen Komponenten können jeweils einen Kühlkörper, vorzugsweise einen Aluminium-Kühlkörper aufweisen. Sie weisen typischerweise einen oder mehrere als central processing unit (CPU) dienenden Prozessor auf. Die Prozessortemperatur während des Betriebs der elektronischen Komponente sollte bei einem vorgegebenen Wert liegen. Unterhalb dieser Temperatur wird die volle Leistung der CPU nicht erreicht, oberhalb dieser Temperatur nimmt die Lebenserwartung der CPU deutlich ab.

Das erfindungsgemäße Modul weist einen Luftleitraum auf, der mittels einer Trennwand in eine erste Kammer und eine zweite Kammer geteilt ist. Vorzugsweise verläuft die erste Kammer an dem Kaltgang und die zweite Kammer an dem Warmgang. Die Trennwand erstreckt sich vorzugsweise orthogonal zur Flächenseite der Wandung des Containers, an die der Luftleitraum angrenzt.

Ist der Luftleitraum am Boden des Containers ausgebildet, so erstreckt sich die Trennwand vorzugsweise in Richtung des Untergrundes, auf dem das Modul steht, wobei das dem Untergrund zugewandte Ende der Trennwand von dem Untergrund beabstandet ist. Eine Luftbewegung unterhalb des Moduls wird von der Trennwand nicht verhindert. Die Trennwand ist vorzugsweise mittig, bezogen auf die Breite des Innenraums, angeordnet. Sie verläuft damit, wenn der Luftleitraum am Boden des Containers ausgebildet ist, unter dem Rack und, falls vorgesehen, dem Schaltschrank. Die Trennwand erstreckt sich unterhalb des Innenraumes vorzugsweise über die gesamte Länge des Bodens des Innenraums.

Ist der Luftleitraum an der Decke des Containers ausgebildet, so erstreckt sich die Trennwand in eine Richtung, die von der Decke des Containers wegführt. Beispielsweise kann sich die Trennwand orthogonal zur Decke erstrecken. Die Trennwand ist vorzugsweise mittig, bezogen auf die Breite des Innenraums, angeordnet. Sie verläuft damit, wenn der Luftleitraum an der Decke des Containers ausgebildet ist, über dem Rack und, falls vorgesehen, dem Schaltschrank. Die Trennwand erstreckt sich oberhalb des Innenraumes vorzugsweise über die gesamte Länge der Decke des Innenraums.

Die erste Kammer und die zweite Kammer haben vorzugsweise die gleiche Größe. Es kann vorgesehen sein, dass der Luftleitraum eine erste Außenwand und eine zweite Außenwand aufweist, wobei sich die erste Außenwand von einer Längskante der Wandung des Containers, an der der Luftleitraum ausgebildet, zu der Trennwand erstreckt und sich die zweite Außenwand von der dieser Längskante gegenüberliegenden Längskante der Wandung erstreckt. Die erste Außenwand und die zweite Außenwand verlaufen in diesem Fall jeweils in einem spitzen Winkel zu der Wandung. Ist der Luftleitraum am Boden des Containers ausgebildet, so wird er dann von dem Boden des Containers, der ersten Außenwand und der zweiten Außenwand begrenzt. Ist der Luftleitraum an der Decke des Containers ausgebildet, so wird er von der Decke des Containers, der ersten Außenwand und der zweiten Außenwand begrenzt. Der Luftleitraum ist an seinen beiden Stirnseiten zweckmäßigerweise jeweils mittels einer stirnseitigen Außenwand begrenzt. Die erste Kammer wird vorzugsweise von der Trennwand, der ersten Außenwand, der Wandung des Containers und Abschnitten der beiden stirnseitigen Außenwände umgrenzt. Die zweite Kammer wird vorzugsweise von der Trennwand, der zweiten Außenwand, der Wandung des Containers und Abschnitten der beiden stirnseitigen Außenwände umgrenzt.

In der Trennwand sind die zweiten, verschließbaren Luftdurchtrittsöffnungen ausgebildet. Die zweiten, verschließbaren Luftdurchtrittsöffnungen können beispielweise mittels einer oder mehrerer Klappen und/oder Schieber realisiert sein. Die Klappen oder Schieber können jeweils ein Stellelement aufweisen, mit dem das Öffnen oder Schließen der zweiten Luftdurchtrittsöffnungen bewirkt werden kann. Das Stellelement kann ein automatisches Stellelement sein. Es ist möglich, die zweiten Luftdurchtrittsöffnungen ganz oder teilweise zu öffnen oder zu verschließen. Weil die zweiten, verschließbaren Luftdurchtrittsöffnungen im geöffneten Zustand einen Luftdurchtritt zwischen den beiden Kammern ermöglichen, werden sie auch als Mischklappen bezeichnet. Es kann vorgesehen sein, dass die zweiten Luftdurchtrittsöffnungen im geöffneten Zustand einen Luftdurchtritt nur von der zweiten Kammer in die erste Kammer gestatten.

In der Außenwand der ersten Kammer sind die dritten, verschließbaren Luftdurchtrittsöffnungen ausgebildet. Die dritten, verschließbaren Luftdurchtrittsöffnungen können beispielweise mittels einer oder mehrerer Klappen und/oder Schieber realisiert sein. Die Klappen oder Schieber können jeweils ein Stellelement aufweisen, mit dem das Öffnen oder Schließen der dritten Luftdurchtrittsöffnungen bewirkt werden kann. Das Stellelement kann ein automatisches Stellelement sein. Es ist möglich, die dritten Luftdurchtrittsöffnungen ganz oder teilweise zu öffnen oder zu verschließen. Die dritten Luftdurchtrittsöffnungen werden auch als erste Außenklappen bezeichnet. Es kann vorgesehen sein, dass die dritten, verschließbaren Luftdurchtrittsöffnungen im geöffneten Zustand nur einen Eintritt von Außenluft in die erste Kammer ermöglichen. Ein Austritt von Luft aus der ersten Kammer durch die dritten Luftdurchtrittsöffnungen ist dann nicht möglich. Unter Außenluft wird dabei Luft aus der Umgebung des erfindungsgemäßen Moduls verstanden.

In der Außenwand der zweiten Kammer sind die vierten, verschließbaren Luftdurchtrittsöffnungen ausgebildet. Die vierten, verschließbaren Luftdurchtrittsöffnungen können beispielweise mittels einer oder mehrerer Klappen und/oder Schieber realisiert sein. Die Klappen oder Schieber können jeweils ein Stellelement aufweisen, mit dem das Öffnen oder Schließen der vierten Luftdurchtrittsöffnungen bewirkt werden kann. Das Stellelement kann ein automatisches Stellelement sein. Es ist möglich, die vierten Luftdurchtrittsöffnungen ganz oder teilweise zu öffnen oder zu verschließen. Die vierten Luftdurchtrittsöffnungen werden auch als zweite Außenklappen bezeichnet. Es kann vorgesehen sein, dass die vierten Luftdurchtrittsöffnungen im geöffneten Zustand nur einen Austritt von Luft aus der zweiten Kammer in die Umgebung ermöglichen. Ein Eintritt von Außenluft in die zweite Kammer durch die vierten Luftdurchtrittsöffnungen ist dann nicht möglich.

Es kann vorgesehen sein, dass in dem Innenraum eine oder mehrere Heizeinrichtungen des erfindungsgemäßen Moduls angeordnet sind. Ein Beispiel einer Heizeinrichtung ist ein Heizkonvektor. Die Heizeinrichtung kann beispielsweise an einer Außenwand des Innenraums angebracht sein. Die Heizeinrichtung ist vorzugsweise im Kaltgang des Innenraumes angeordnet. Das ist vorteilhaft, wenn dort Wärme benötigt wird, die zum Starten des erfindungsgemäßen Verfahrens erforderlich sein kann. Die Heizvorrichtung ist insbesondere für die Inbetriebnahme des erfindungsgemäßen Moduls oder des erfindungsgemäßen Rechenzentrums vorgesehen. So kann es beispielsweise bei Temperaturen unterhalb einer Mindesttemperatur zweckmäßig sein, zunächst den Kaltgang mittels der Heizeinrichtungen auf die Mindesttemperatur zu erwärmen. Die Heizeinrichtungen können abgeschaltet werden, sobald die vorgegebene Starttemperatur für die elektronischen Komponenten erreicht ist. Die Mindesttemperatur kann beispielsweise bei 10 °C liegen. Die Starttemperatur kann der Mindesttemperatur entsprechen oder höher als diese sein. Vorzugsweise liegt sie nur gering über der Mindesttemperatur, beispielsweise nur 2 Grad oder weniger, besonders bevorzugt nur 1 Grad oder weniger. In einer Ausführungsform der Erfindung sind drei Heizkonvektoren mit einer Leistung von jeweils 5 bis 15 kW vorgesehen.

Die ersten Luftdurchtrittsöffnungen sind in der Wandung des Containers ausgebildet, an die der Luftleitraum angrenzt. Durch die ersten Luftdurchtrittsöffnungen sind der Innenraum und der Luftleitraum des erfindungsgemäßen Moduls miteinander verbunden. Vorzugsweise sind erste erste Luftdurchtrittsöffnungen im Bereich des Kaltganges ausgebildet. Diese Luftdurchtrittsöffnungen verbinden die erste Kammer mit dem Kaltgang. Vorzugsweise sind zweite erste Luftdurchtrittsöffnungen im Bereich des Warmganges ausgebildet. Diese Luftdurchtrittsöffnungen verbinden die Warmgang mit der zweiten Kammer. Die ersten Luftdurchtrittsöffnungen können von den Öffnungen der Gitterroste, die den standardgemäßen Boden eines ISO-Containers ersetzen, gebildet sein. Die ersten Luftdurchtrittsöffnungen sind nicht verschlossen.

Es kann vorgesehen sein, dass das erfindungsgemäße Modul eine Steuereinrichtung zur Steuerung des Öffnens und/oder Verschließens der verschließbaren Luftdurchtrittsöffnungen aufweist. Die Steuereinrichtung kann auch zur Steuerung der Drehzahl der Lüfter der elektronischen Komponenten vorgesehen sein. Eine Steuerung der Drehzahl der Lüfter kann jedoch aber auf anderem Wege, beispielsweise mittels einer Steuereinheit der elektronischen Komponente, deren Bestandteil der Lüfter ist, vorgenommen werden. Bei der Steuereinrichtung kann es sich um eine speicherprogrammierbare Steuerung (SPS) handeln. Die Steuereinrichtung kann außerhalb des Moduls, beispielsweise in einem gesonderten Container, untergebracht sein. Die Steuereinrichtung kann aber auch im Modul, beispielsweise im Schaltschrank untergebracht sein. Vorzugsweise wird die Steuereinrichtung mittels einer unterbrechungsfreien Stromversorgung (USV) mit elektrischem Strom versorgt, um eine lückenlose Kontrolle und Überwachung des Moduls sicherzustellen. Insbesondere im Havariefall sowie bei Umwelteinflüssen jenseits der Vorgaben können die zweiten, dritten und vierten Luftdurchtrittsöffnungen geschlossen werden, um Beschädigungen des erfindungsgemäßen Moduls und/oder an den elektronischen Komponenten, beispielsweise den Servern, zu verhindern.

Zur Messung der Temperatur innerhalb des Moduls können ein oder mehrere Temperatursensoren vorgesehen sein. Beispielsweise können ein oder mehrere Temperatursensoren im Kaltgang des Moduls angeordnet sein, um die Temperatur der Luft im Kaltgang zu bestimmen. Alternativ oder zusätzlich können ein oder mehrere Temperatursensoren im Warmgang des Moduls angeordnet sein, um die Temperatur der Luft im Warmgang zu bestimmen. Alternativ oder zusätzlich kann ein Temperatursensor in der ersten Kammer des Moduls angeordnet sein, um die Temperatur der Luft in der ersten Kammer zu bestimmen. Alternativ oder zusätzlich kann ein Temperatursensor in der zweiten Kammer des Moduls angeordnet sein, um die Temperatur der Luft in der zweiten Kammer zu bestimmen. Die gemessenen Temperaturen können beispielsweise für die Inbetriebnahme dieses Moduls eines erfindungsgemäßen Rechenzentrums und/oder zur Regelung des Öffnens und Schließens der zweiten, dritten und vierten Luftdurchtrittsöffnungen verwendet werden. Der oder die Temperatursensoren im Kaltgang des Moduls können insbesondere bei der Inbetriebnahme des Rechenzentrums verwendet werden. Zusätzlich zu dem oder den Temperatursensoren im Kaltgang, dem oder den Temperatursensoren im Warmgang, dem Temperatursensor in der ersten Kammer und/oder dem Temperatursensor in der zweiten Kammer können eine oder mehrere der folgenden Messeinrichtungen vorgesehen sein: eine oder mehrere Temperatursensoren zur Bestimmung der Außentemperatur, eine oder mehrere Einrichtungen zur Messung der Windgeschwindigkeit, eine oder mehrere Einrichtungen zur Messung weiterer Umwelteinflüsse, beispielsweise der Luftfeuchtigkeit. Diese Messeinrichtungen können außerhalb des Innenraumes und des Luftleitraums befestigt sein, beispielsweise außen an dem Container. Messwerte, die von diesen Messeinrichtungen erhalten werden, können beispielsweise zur Regelung des Öffnens und Schließens der zweiten, dritten und vierten Luftdurchtrittsöffnungen verwendet werden. Die Werte, die mittels der Temperatursensoren und, falls vorgesehen, der Messeinrichtungen ermittelt werden, können an die Steuereinrichtung übertragen und dort zur Regelung des Öffnens und Schließens der zweiten, dritten und vierten Luftdurchtrittsöffnungen verwendet werden.

Nach Maßgabe der Erfindung ist ferner ein Rechenzentrum vorgesehen, das ein oder mehrere erfindungsgemäße Module aufweist, wobei in dem Rack jedes Moduls elektronische Komponenten angeordnet sind, die jeweils zumindest einen Lüfter aufweisen. Bei den elektronischen Komponenten kann es sich um die oben beschriebenen elektronischen Komponenten, beispielsweise Computer wie Server, handeln. Die elektronischen Komponenten sollten jeweils einen Lüfter aufweisen. Sie können ferner Kühlkörper, beispielsweise Aluminiumkühlkörper, aufweisen. Das Rechenzentrum kann weitere Einrichtungen aufweisen, beispielsweise Kabel für die Versorgung der elektronischen Komponenten mit elektrischem Strom und Netzwerkkabel.

Es kann vorgesehen sein, dass das erfindungsgemäße Rechenzentrum eine Steuereinrichtung zur Steuerung des Öffnens und/oder Verschließens der verschließbaren Luftdurchtrittsöffnungen des oder der Module des Rechenzentrums aufweist. Bei der Steuereinrichtung kann es sich um eine speicherprogrammierbare Steuerung (SPS) handeln. Die Steuereinrichtung kann in einem gesonderten Container untergebracht sein. Vorzugsweise wird die Steuereinrichtung mittels einer unterbrechungsfreien Stromversorgung (USV) mit elektrischem Strom versorgt, um eine lückenlose Kontrolle und Überwachung des oder der Module des Rechenzentrums sicherzustellen.

Nach Maßgabe der Erfindung ist außerdem ein Verfahren zur Temperierung des erfindungsgemäßen Rechenzentrums vorgesehen, wobei mittels der verschließbaren Luftdurchtrittsöffnungen die Temperatur im Innenraum eines Moduls eingestellt wird. Die verschließbaren Luftdurchtrittsöffnungen sind die zweiten, dritten und vierten Luftdurchtrittsöffnungen. Zur Temperierung des Innenraumes eines Moduls des erfindungsgemäßen Rechenzentrums kann mittels der verschließbaren Luftdurchtrittsöffnungen (i) ein Luftstrom im geschlossenen Kreislauf zwischen dem Innenraum und dem Luftleitraum geführt werden, (ii) eine Ansaugung von Außenluft über eine Kammer des Luftleitraumes und die Abgabe von Luft an die Umgebung über eine andere Kammer des Luftleitraumes erfolgen oder (iii) die Mischung von Außenluft mit Luft, die im Kreislauf geführt wird, vorgenommen werden.

Es kann vorgesehen sein, dass, wenn die Innentemperatur in dem Innenraum, beispielsweise gemessen im Kaltgang, eines Moduls unterhalb einer Betriebstemperatur liegt, die zweiten Luftdurchtrittsöffnungen geöffnet und die dritten und vierten Luftdurchtrittsöffnungen geschlossen werden, so dass mittels der Lüfter der elektronischen Komponenten Luft zwischen dem Innenraum und dem Luftleitraum in einem Kreislauf geführt werden kann. Wenn die Innentemperatur in dem Innenraum, beispielsweise gemessen im Kaltgang, eines Moduls bei oder oberhalb der Betriebstemperatur liegt, können die zweiten Luftdurchtrittsöffnungen geschlossen und die dritten und vierten Luftdurchtrittsöffnungen geöffnet werden, so dass mittels der Lüfter der elektronischen Komponenten Luft über die dritten Luftdurchtrittsöffnungen aus der Umgebung in die erste Kammer eingesaugt wird, von dort über den Kaltgang und den Warmgang in die zweite Kammer gelangt und aus der zweiten Kammer über die vierten Luftdurchtrittsöffnungen an die Umgebung abgegeben wird. Die Betriebstemperatur ist eine Temperatur, die vom Betreiber des Rechenzentrums vorgegeben werden. Sie ist typischerweise von den Spezifikationen der elektronischen Komponenten abhängig. Die Betriebstemperatur kann beispielsweise eine Temperatur in einem Bereich von 20 bis 30 °C, vorzugsweise 23 bis 27 °C und besonders bevorzugt 25 °C sein. Anstelle der Innentemperatur in dem Innenraum kann auch eine von der Außentemperatur abgeleiteter Wert verwendet werden.

Das Rechenzentrum ist in Betrieb, wenn die elektronischen Komponenten arbeiten, also beispielsweise die Server in Betrieb sind. Zur Inbetriebnahme des Rechenzentrums ist eine Temperatur erforderlich, die bei oder über der Mindesttemperatur liegt. Erst wenn diese Mindesttemperatur erreicht ist, sollten die Lüfter und anschließend die übrigen Bestandteile der elektronischen Komponenten gestartet werden. Zum Erreichen der Mindesttemperatur im Innenraum eines erfindungsgemäßen Moduls kann folgendermaßen vorgegangen werden. Die zweiten, dritten und vierten Luftdurchtrittsöffnungen werden, sofern dies nicht bereits der Fall ist, verschlossen. Damit wird sichergestellt, dass keine Wärme aus dem Innenraum und dem Luftleitraum des Moduls entweichen kann. Anschließend wird mittels der oder den Heizeinrichtungen die Innentemperatur im Kaltgang auf die Mindesttemperatur, beispielsweise 10 °C, durch Erwärmung der dort befindlichen Luft erhöht. Sobald die Mindesttemperatur erreicht ist, werden die Lüfter der elektronischen Komponenten in Betrieb genommen. Vorzugsweise wird zunächst eine geringe Drehzahl der Lüfter vorgegeben. Die Lüfter fördern nun die erwärmte Luft aus dem Kaltgang in den Warmgang. Dabei werden, falls vorhanden, die Kühlkörper der elektronischen Komponenten erwärmt. Die Förderung der erwärmten Luft von dem Kaltgang in den Warmgang führen zu einem Überdruck im Warmgang. Werden nun die dritten Luftdurchgangsöffnungen geöffnet, so strömt Luft über die zweite Kammer des Luftleitraums in dessen erste Kammer und vor dort in den Kaltgang. Dort wird die Luft mittels des oder der Heizeinrichtungen weiter erwärmt und mittels der Lüfter wieder in den Warmgang befördert, so dass eine Führung der Luft im geschlossenen Kreislauf erreicht wird, wobei sich die Luft immer weiter erwärmt. Sobald die Starttemperatur für die elektronischen Komponenten erreicht wird, werden diese gestartet und die Lüfter auf eine Drehzahl geregelt, die der Temperatur der Prozessoren entspricht. Die Prozessoren der elektronischen Komponenten erzeugen nun Wärme. Die Heizeinrichtung(en) können nun abgeschaltet werden. Die Luft kann weiter im geschlossenen Kreislauf geführt werden, bis die Betriebstemperatur erreicht wird. Wird die Betriebstemperatur erreicht oder überschritten können die zweiten Luftdurchtrittsöffnungen geschlossen und die dritten und vierten Luftdurchtrittsöffnungen geöffnet werden, so dass mittels der Lüfter der elektronischen Komponenten Luft über die dritten Luftdurchtrittsöffnungen aus der Umgebung in die erste Kammer eingesaugt wird, von dort über den Kaltgang und den Warmgang in die zweite Kammer gelangt und aus der zweiten Kammer über die vierten Luftdurchtrittsöffnungen an die Umgebung als Abluft abgegeben wird. Die Zufuhr von Außenluft, das ist die Zuluft, bewirkt eine Abkühlung der Luft, die in den Kaltgang gelangt. Die Temperatur der Außenluft sollte daher nicht oberhalb der vorgegebenen Betriebstemperatur liegen, vorzugsweise liegt sie darunter. Die Betriebstemperatur wird vorzugsweise im Kaltgang des Innenraums gemessen.

Das Öffnen und Schließen der zweiten Luftdurchtrittsöffnungen kann stückweise vorgenommen werden. Auf diese Weise kann beeinflusst werden, in welchem Umfang Außenluft als Zuluft angesaugt und warme Abluft abgegeben wird. Sind die zweiten Luftdurchtrittsöffnungen geschlossen, wird die Luft vollständig ausgetauscht, sind sie nur teilweise geöffnet, so wird Außenluft zugemischt. In diesem Fall kann mittels der Lüfter der elektronischen Komponenten Außenluft aus der Umgebung über die dritten Luftdurchtrittsöffnungen in die erste Kammer eingesaugt werden, von dort über den Kaltgang und den Warmgang in die zweite Kammer gelangen und aus der zweiten Kammer zum einem Teil über die vierten Luftdurchtrittsöffnungen an die Umgebung abgegeben und zu einem anderen Teil im Kreislauf zurück in die erste Kammer geführt werden.

Das Öffnen und Schließen der zweiten, dritten und vierten Luftdurchtrittsöffnungen erfolgt vorzugsweise automatisch mittels der Steuereinrichtung, beispielsweiser einer SPS. Zur Steuerung des Öffnens und Schließens der zweiten, dritten und vierten Luftdurchtrittsöffnungen können neben den Werten, die mittels der Temperatursensoren und/oder der Messeinrichtungen des erfindungsgemäßen Moduls ermittelt werden, auch Werte einer externen Wetterstation berücksichtigt werden. Das erfindungsgemäße Verfahren ermöglicht je nach Außentemperatur und Wärmeabgabe der elektronischen Komponenten, insbesondere der Server, die Einstellung eines optimalen Temperaturregimes im Innenraum des oder der erfindungsgemäßen Module. Das Öffnen und Schließen der zweiten, dritten und vierten Luftdurchtrittsöffnungen kann mittels der im Innenraum eines Moduls angebrachten Temperatursensoren und/oder der Messeinrichtungen selbstständig gesteuert werden. Die Werte der externen Wetterstation können genutzt werden, um Vorkehrungen zutreffen, wenn Extremwetterereignisse angekündigt werden. Das Öffnen und Schließen der zweiten, dritten und vierten Steuereinrichtungen kann alternativ zur automatischen Steuerung auch direkt von einem Operator, beispielsweise durch Fernzugriff, was auch als remote bezeichnet wird, oder über einen Eingabemonitor im Rechenzentrum, vorgenommen werden. Das ist insbesondere sinnvoll, wenn kurzfristig auf extreme Wetterereignisse reagiert werden soll.

Das erfindungsgemäße Modul ermöglicht die Errichtung und den Betrieb eines Rechenzentrums, das - abgesehen von den elektronischen Komponenten selbst - keine aktiven Lüftungselemente, wie beispielsweise Lüfter, und/oder Kühlungselemente, wie beispielsweise Wärmeaustauscher, erfordert. Die elektronischen Komponenten sind selbst die aktiven Lüftungselemente. Damit wird im Gegensatz zu bisherigen Lösungen eine hohe Integrierbarkeit zu niedrigsten Kosten erreicht. Aufgrund der erforderlichen aktiven Kühlung sind die bisher bekannten Module für Rechenzentren und damit die Rechenzentren selbst teuer in Errichtung und Betrieb. Die Erfindung ermöglicht eine selbst-regulierende Thermik innerhalb eines Moduls durch eine Temperierung, d. h. insbesondere Kühlung, mit Außenluft. Das erfindungsgemäße Modul und das erfindungsgemäße Rechenzentrum sind insbesondere für das Hochleistungsrechnen (HPC), unter anderem für die Blockchain-Verifikation, einschließlich der Berechnung des Proof-of-Work (PoW), geeignet. Damit kann beispielsweise das Bitcoin-Mining vorteilhaft durchgeführt werden. Das erfindungsgemäße Modul und das erfindungsgemäße Rechenzentrum sind darüber hinaus mobil einsetzbar, weil sowohl das Modul als auch das Rechenzentrum, das eines oder mehrere dieser Module umfasst, schnell und kostengünstig errichtet, abgebaut und transportiert werden können. Es wird ein Rechenzentrum erreicht, das einen Datacenter-Raum schafft, der den T1-Vorgaben entspricht.

Das erfindungsgemäße Modul und das erfindungsgemäße Rechenzentrum sind in hohem Maße mobil, verfügbar, ressourcenschonend, passiv nutzbar und bieten eine hohe Integration bei geringem Platzbedarf. Die Integrationsdichte, die mittels des erfindungsgemäßen Moduls und des erfindungsgemäßen Rechenzentrums erreicht werden kann, liegt vier bis fünfmal über der des Standes der Technik.

Weist das erfindungsgemäße Rechenzentrum mehrere der erfindungsgemäßen Module auf, so können die Module dezentral, beispielsweise geographisch weit voneinander getrennt, errichtet und zu einem logischen Rechenzentrum zusammengefasst werden. Damit wird eine größere Ausfallsicherheit im Gesamtzusammenspiel aller Module des logischen Rechenzentrums erzielt. Sollte ein Modul ausfallen, so können die Aufgaben des ausgefallenen Moduls automatisch von einem anderen Modul, das an einem geographisch anderen Standpunkt aufgestellt ist, übernommen werden. Dies führt zu einer extrem hohen Ausfallsicherheit nahe an einem T3-Environment. Unter "T3" wird eine Datenübertragungsgeschwindigkeit von 44,736 Mbit/s verstanden.

Die Erfindung wird nachstehend anhand von Ausführungsbeispielen, die die Erfindung nicht einschränken sollen, unter Bezugnahme auf die Zeichnungen näher erläutert. Dabei zeigen
- Fig. 1: eine schematische perspektivische Darstellung einer Ausführungsform eines erfindungsgemäßen Moduls;
- Fig. 2: eine schematische Seitenansicht der in Fig. 1 gezeigten Ausführungsform eines erfindungsgemäßen Moduls, wobei die Treppe nicht dargestellt ist;
- Fig. 3: eine schematische Schnittdarstellung der in Fig. 1 gezeigten Ausführungsform eines erfindungsgemäßen Moduls entlang Schnittlinie A--A in Fig. 2;
- Fig. 4: eine schematische Draufsicht auf den Boden der in Fig. 1 gezeigten Ausführungsform eines erfindungsgemäßen Moduls;
- Fig. 5: eine schematische perspektivische Darstellung eines aufgeständerten ISO-Containers;
- Fig. 6: eine schematische perspektivische Darstellung des in Fig. 5 gezeigten aufgeständerten ISO-Containers mit angebrachtem Bodenraum;
- Fig. 7: schematische Schnittdarstellungen einer Ausführungsform eines Rechenzentrums mit unterschiedlichen Stellungen der Mittelklappen und der Außenklappen zur Veranschaulichung der Luftbewegungen (Fig. 7a: geschlossener Kreislauf; Fig. 7b: Zumischung von Außenluft unter teilweiser Kreislaufführung der Luft; Fig. 7c: vollständige Abführung der Luft); und
- Fig. 8: eine schematische Darstellung eines Verbundes aus mehreren Rechenzentren.

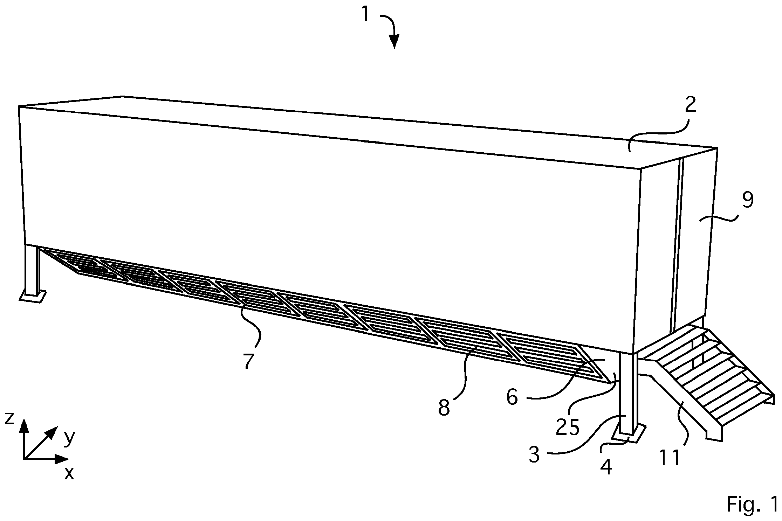

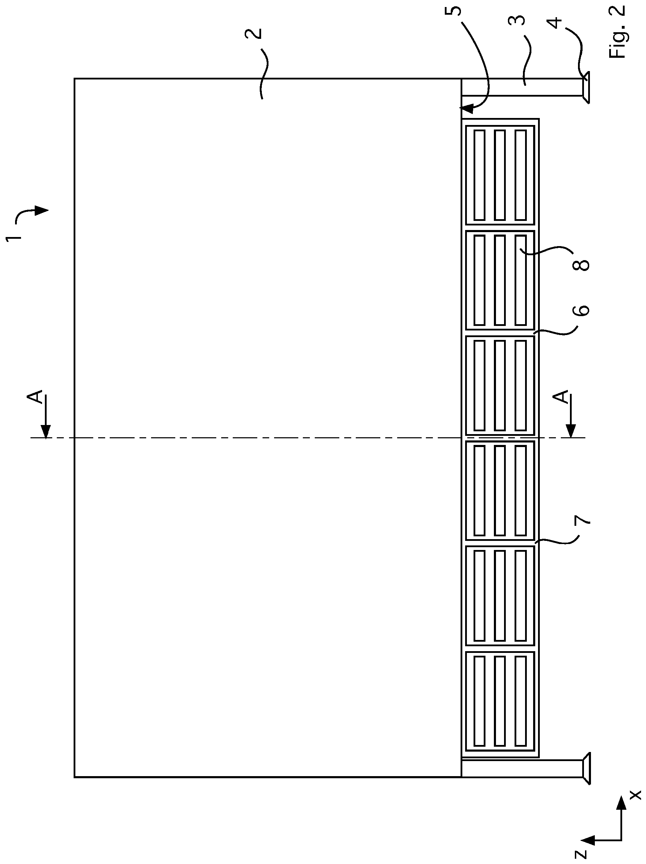

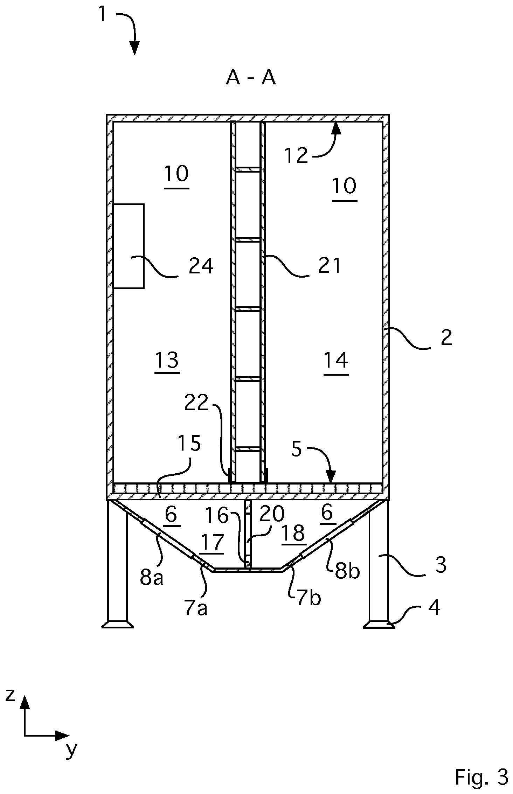

Die in den Figuren 1 bis 4 gezeigte Ausführungsform eines erfindungsgemäßen Moduls 1 weist einen 40-Fuß-ISO-Container 2 auf, dessen Boden 5 von Trittgitterrosten gebildet ist und der auf Stützen 3 steht, die mittels Abstützplatten 4 vor dem Einsinken in den Untergrund geschützt sind. Am Boden 5 des Containers 2 ist der Luftleitraum angebracht, der im Folgenden als Bodenraum 6 bezeichnet wird. In den Außenwänden 7 des Bodenraums 6 sind Luftdurchtrittsöffnungen in Form von Klappen 8 ausgebildet. Diese Klappen werden im Folgenden als Außenklappen bezeichnet. An einer Stirnseite des Containers 2 sind Türen 9 ausgebildet, die einen Zugang zum Innenraum 10 des Containers 2 gewähren. Zum Erreichen der Türen 9 weist das Modul 1 eine Treppe 11 auf. Der Bodenraum 6 wird an seinen Stirnseiten durch die stirnseitigen Außenwände begrenzt.

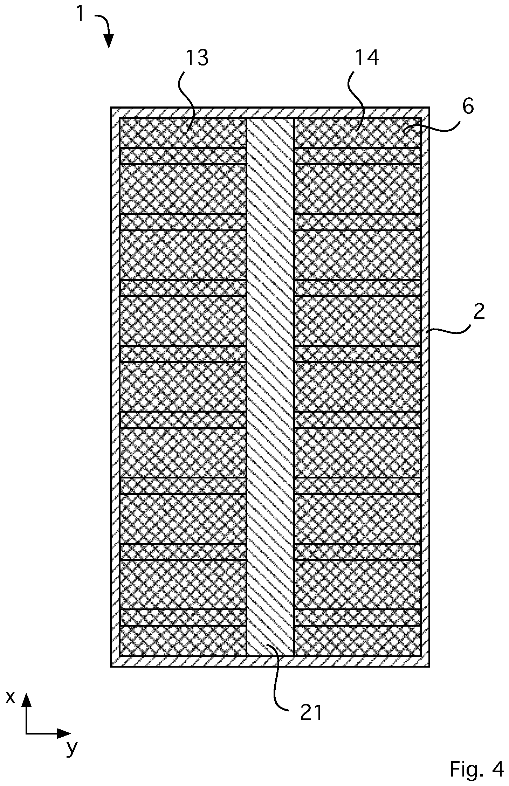

Der Container 2 umgrenzt einen Innenraum 10, in dem ein als Rack 21 bezeichnetes Regal aufgestellt ist. Das Rack 21 ist über einen Profilrahmen 22 am Boden 5 des Containers befestigt. Es weist einen Rahmen auf, der sich vom Boden 5 des Containers 2 bis zu dessen Decke 12 erstreckt. Der Rahmen, der bezogen auf die Breite des Innenraumes (y-Koordinate) mittig angeordnet ist, teilt den Innenraum 10 in einen Kaltgang 13 und einen Warmgang 14, die zumindest annähernd strömungsdicht mittels des Racks 21 voneinander getrennt sind. Der Boden 5 trennt den Innenraum 10 von dem Bodenraum 6. Dabei liegt der Boden 5 auf den Bodenquer- und -längsträgern 15, 23 des Containers 2 auf. Im Bodenraum 6 befindet sich eine Trennwand 16, die sich orthogonal vom Boden 5 in Richtung des Untergrundes, auf dem das Modul 1 steht, erstreckt, von diesem allerdings beabstandet ist. Die Trennwand 16, die bezogen auf die Breite des Innenraumes (y-Koordinate), mittig angeordnet ist, teilt den Bodenraum 6 in eine erste Kammer 17, die unterhalb des Kaltganges 13 verläuft, und eine zweite Kammer 18, die unterhalb des Warmganges 14 verläuft. Über erste Luftdurchtrittsöffnungen 19 (siehe Fig. 4) im Boden 5 des Containers 2 ist die erste Kammer 17 mit dem Kaltgang 13 und die zweite Kammer 18 mit dem Warmgang 14 verbunden.

In der Trennwand 16 sind zweite, verschließbare Luftdurchtrittsöffnungen in Form von Klappen ausgebildet, die im Folgenden als Mischklappen 20 bezeichnet werden und einen Luftstrom von der zweiten Kammer 18 in die erste Kammer 17 erlauben. Von der Längskante des Containers 2, bei dem es sich um einen äußeren Bodenlängsträger des Containers 2 handeln kann, erstreckt sich eine erste Außenwand 7a, die die erste Kammer 17 begrenzt, im spitzen Winkel in Richtung der Trennwand 16. Von der gegenüberliegenden Längskante des Containers 2, bei dem es sich um einen äußeren Bodenlängsträger des Containers 2 handeln kann, erstreckt sich eine zweite Außenwand 7b, die die zweite Kammer 18 begrenzt, im spitzen Winkel in Richtung der Trennwand 16. In der ersten Außenwand 7a sind die dritten Luftdurchtrittsöffnungen in Form von Klappen 8a, die im Folgenden als erste Außenklappen bezeichnet werden, in der zweiten Außenwand 7b sind die vierten Luftdurchtrittsöffnungen in Form von Klappen 8b, die im Folgenden als zweite Außenklappen bezeichnet werden, ausgebildet. Im Kaltgang 13 sind an einer Außenwand des Containers 2 Heizkonvektoren 24 angebracht.

Es sei darauf hingewiesen, dass der Luftleitraum nicht zwingend als Bodenraum ausgebildet sein muss. Er kann beispielsweise auch an der Decke des Containers 2 ausgebildet sein.

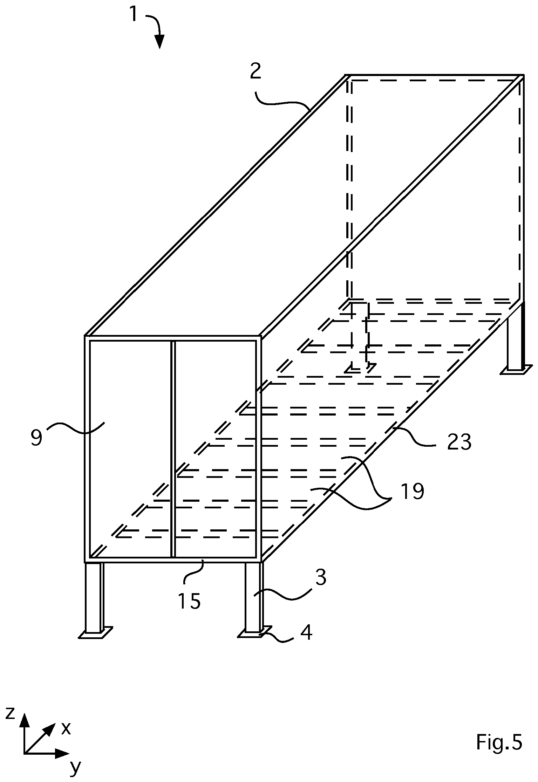

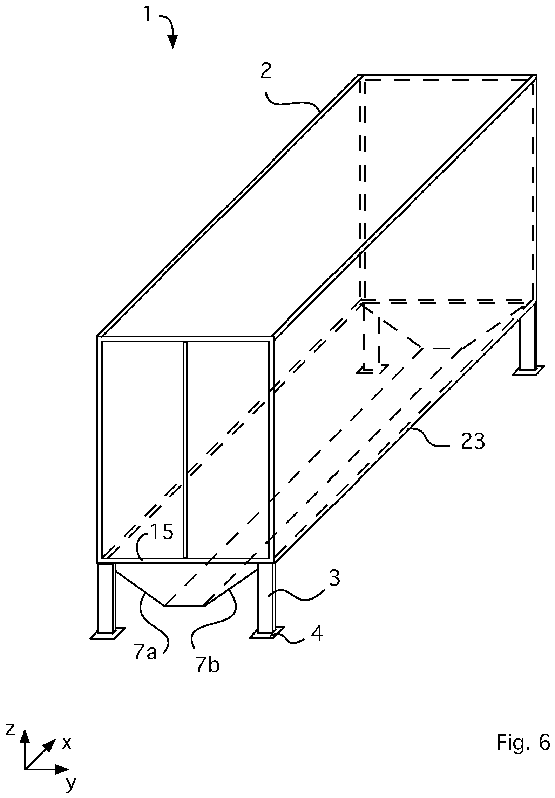

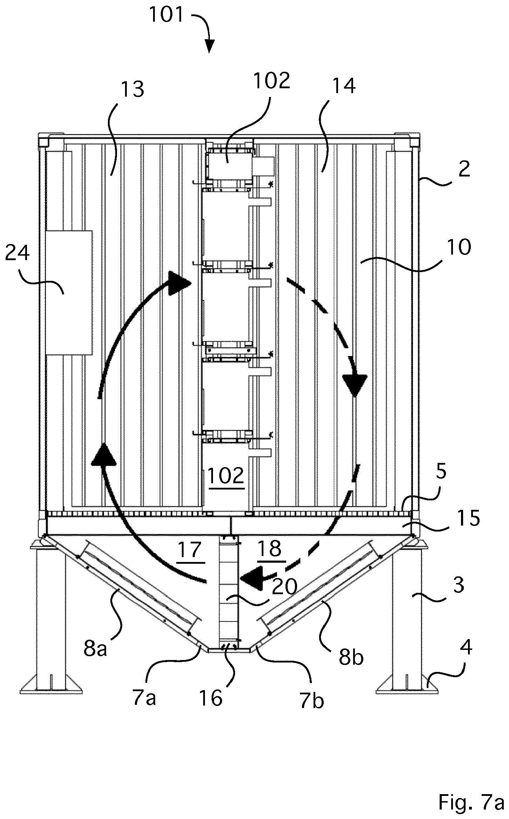

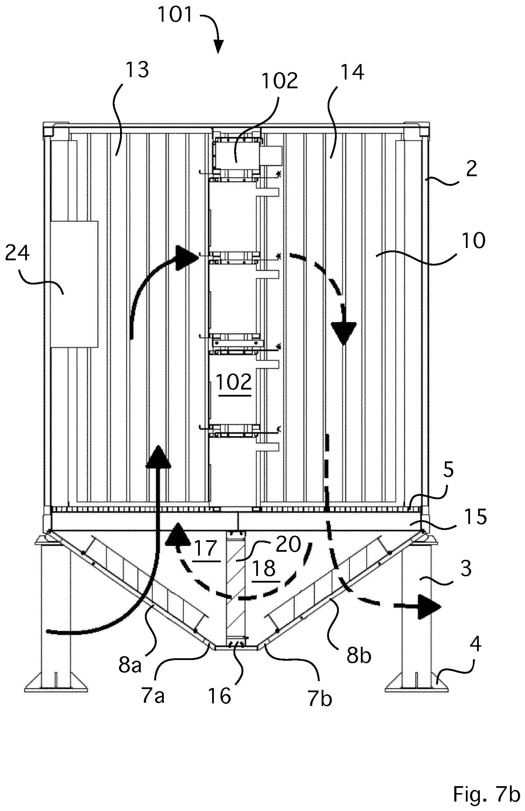

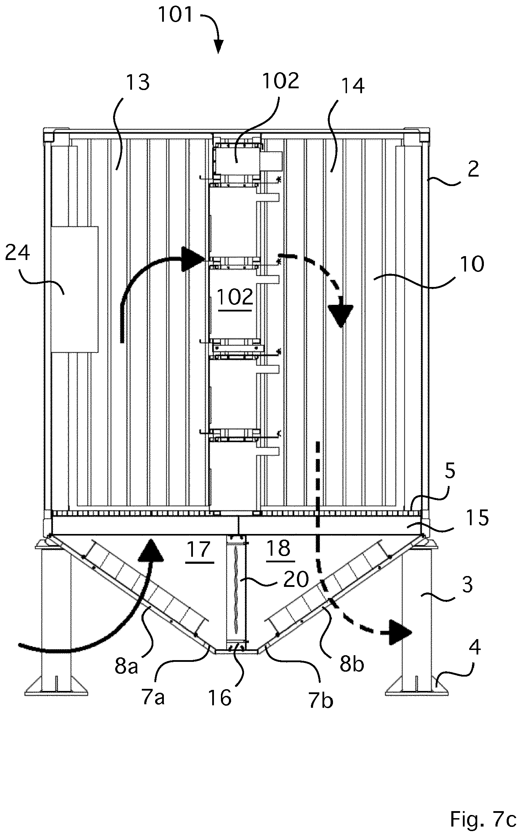

Die Figuren 5 und 6 veranschaulichen die Herstellung eines erfindungsgemäßen Moduls 1. Zunächst wird ein Container 2, der bereits mit einem Rack 21 ausgestattet sein kann, aufgeständert, indem an den Eckbeschlägen des Containers 2, die sich an Verbindungstellen zwischen den äußeren Bodenlängsträgern 23 und den äußeren Bodenquerträgern befinden, vier Stützen 3, die an ihrem Fuß jeweils eine Abstützplatte 4 tragen können, angebracht werden (Fig. 5). An den Container 2 wird der Bodenraum 6 montiert (Fig. 7). Der Boden 5 ist in den Figuren 5 und 6 nicht dargestellt. Er wird von Gitterrosten gebildet, die die ersten Luftdurchtrittsöffnungen aufweisen.

Die Figuren 7a bis 7c zeigen schematische Schnittdarstellungen einer Ausführungsform eines Rechenzentrums. Das Rechenzentrum weist in der gezeigten Ausführungsform ein Modul 101 auf, das dem in den Figuren 1 bis 4 gezeigten Modul entspricht, in dessen Rack 21 Server 102, die jeweils zwei Lüfter aufweisen, angeordnet sind. Dabei sind in dem Rack 21 ein oder mehr, beispielsweise vier Reihen von Servern 102 vorgesehen, wobei die Server 102 in den drei unteren Reihen senkrecht und in der oberen Reihe waagerecht angeordnet sind. Außerdem sind in dem Innenraum 10 weitere Bestandteile, die zum Betrieb des Rechenzentrums erforderlich sind, untergebracht, beispielsweise Strom- und Netzwerkkabel. Die Pfeile mit durchgehender Linie veranschaulichen Kaltluft, die Pfeile mit gestrichelter Linie veranschaulichen Warmluft. Die Bewegung der Luft wird durch die Lüfter der Server 102 bewirkt.

In Fig. 7a befindet sich das Modul 101 in einem ersten Zustand, bei dem die Mischklappe 20 vollständig geöffnet und die erste und zweite Außenklappe 8a, 8b geschlossen sind, so dass mittels der Lüfter der Server 102 Luft zwischen dem Innenraum 10 und dem Bodenraum 6 im geschlossenen Kreislauf geführt wird. Kaltluft wird von den Lüftern aus dem Kaltgang 13 in den Warmgang 14 befördert. Dabei passiert sie die Kühlkörper der Server 102, deren Prozessoren bei einer Prozessortemperatur arbeiten, die idealerweise 90 °C beträgt. Der Luftstrom kühlt die Kühlkörper ab, während sich die Luft erwärmt, so dass in den Warmgang 14 Warmluft eintritt. Diese gelangt durch erste Luftdurchtrittsöffnungen 19 im Boden 5 in die zweite Kammer 18 des Bodenraums 6, tritt durch die Mischklappe 20 in die erste Kammer 17 und gelangt von dort durch erste Luftdurchtrittsöffnungen im Boden 5 in den Kaltgang 13. Auf dem Weg vom Warmgang 14 durch die zweite und erste Kammer 18, 17 hat sich die Luft wieder abgekühlt, so dass in den Kaltgang Kaltluft gelangt. Das Modul 101 wird vorzugsweise im ersten Zustand betrieben, wenn die Innentemperatur im Kaltgang unter der Betriebstemperatur und über der Mindesttemperatur liegt. Das ist insbesondere bei der Inbetriebnahme des Moduls 101 der Fall.

In Fig. 7b befindet sich das Modul 101 in einem zweiten Zustand, bei dem die Mischklappe 20 teilweise geöffnet und die erste und zweite Außenklappe 8a, 8b teilweise geöffnet sind, so dass mittels der Lüfter der Server 102 kalte Außenluft über die erste Außenklappe 8a angesaugt wird. Die Außenluft gelangt in die erste Kammer 17 und mischt sich dort mit dem aus der zweiten Kammer 18 stammenden ersten Teilstrom an Luft, die sich dadurch abkühlt. Die Kaltluft gelangt von der ersten Kammer 17 durch erste Luftdurchtrittsöffnungen 19 im Boden 5 in den Kaltgang 13. Vom Kaltgang 13 wird die Kaltluft von den Lüftern in den Warmgang 14 befördert. Dabei passiert sie die Kühlkörper der Server 102, deren Prozessoren bei einer Prozessortemperatur arbeiten. Der Luftstrom kühlt die Kühlkörper ab, während sich Luft erwärmt, so dass in den Warmgang 14 Warmluft eintritt. Diese gelangt durch erste Luftdurchtrittsöffnungen im Boden 5 in die zweite Kammer 18 des Bodenraums 6 und teilt sich dort in einen ersten Strom, der durch die Mischklappe 20 in die erste Kammer 17 eintritt, und einen zweiten Strom, der durch die zweiten Außenklappen 8b in der zweiten Außenwand in die Umgebung austritt. Im zweiten Zustand wird somit Außenluft zugemischt, um eine Abkühlung der Luft zu erreichen, die in den Kaltgang gelangt. Der Anteil an zugemischter Außenluft kann durch den Grad der Öffnung der Mischklappe und der Außenklappen 8a, 8b bestimmt werden. Der Anteil an zugemischter Außenluft ist umso größer, je stärker die Außenklappen und je geringer die Mischklappe 20 geöffnet ist. Das Modul 101 wird vorzugsweise im zweiten Zustand betrieben, wenn die Innentemperatur im Kaltgang bei oder über der Betriebstemperatur liegt. Die Außentemperatur muss unter der Temperatur liegen, mit der der erste Teilstrom in die erste Kammer eintritt.

In Fig. 7c befindet sich das Modul 101 in einem dritten Zustand, bei dem die Mischklappe 20 vollständig geschlossen und die erste und zweite Außenklappe 8a, 8b vollständig geöffnet sind, so dass mittels der Lüfter der Server 102 kalte Außenluft über die erste Außenklappe 8a angesaugt wird. Die Außenluft gelangt in die erste Kammer 17. Sie gelangt als Kaltluft von dort durch erste Luftdurchtrittsöffnungen im Boden 5 in den Kaltgang 13. Vom Kaltgang 13 wird die Kaltluft von den Lüftern in den Warmgang 14 befördert. Dabei passiert sie die Kühlkörper der Server 102, deren Prozessoren bei einer Prozessortemperatur arbeiten. Der Luftstrom kühlt die Kühlkörper ab, während sich Luft erwärmt, so dass in den Warmgang 14 Warmluft eintritt. Diese gelangt durch erste Luftdurchtrittsöffnungen 19 im Boden 5 in die zweite Kammer 18 des Bodenraums 6 und tritt durch die zweiten Außenklappen 8b in der zweiten Außenwand in die Umgebung aus. Das Modul 101 wird vorzugsweise im dritten Zustand betrieben, wenn die Innentemperatur im Kaltgang über der Betriebstemperatur liegt. Die Außentemperatur muss unter der Temperatur liegen, mit der die Luft aus der zweiten Kammer in die Umgebung austritt. Im dritten Zustand wird eine raschere und/oder stärkere Kühlung erreicht. Es ist bevorzugt, dass das Modul im dritten und nicht im zweiten Zustand betrieben wird. Der zweite Zustand stellt einen Übergang vom ersten zum dritten Zustand dar, der sich während dieses Übergangs zwangsläufig ergibt.

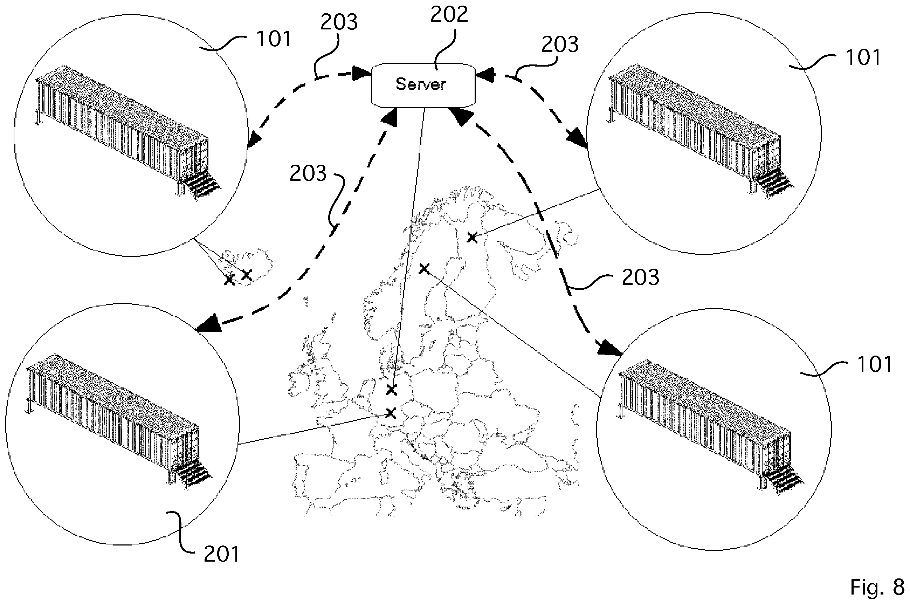

Fig. 8 zeigt einen Verbund aus mehreren Rechenzentren, wobei der Verbund erste Rechenzentren mit erfindungsgemäßen Modulen 101 und zweite Rechenzentren 201 umfasst. Die Rechenzentren sind jeweils mit einem zentralen Server 202 über Datenleitungen 203 verbunden. Die ersten Rechenzentren mit erfindungsgemäßen Modulen 101 sind Rechenzentren gemäß der Erfindung, die jeweils zumindest ein Modul 101 aufweisen. Die ersten Rechenzentren sollen sich wie in Fig. 8 an der Landkarte Europas zu erkennen ist, in geographischen Bereichen befinden, deren durchschnittliche Jahreshöchsttemperatur 25 °C nicht übersteigt. Das zweite Rechenzentrum 201 kann ein Rechenzentrum nach dem Stand der Technik sein.

### Bezu gszeichenliste

- 1: Modul
- 2: Container
- 3: Stütze
- 4: Abstützplatte
- 5: Boden
- 6: Bodenraum
- 7: Außenwand
- 8: Außenklappe
- 9: Tür
- 10: Innenraum
- 11: Treppe
- 12: Decke
- 13: Kaltgang
- 14: Warmgang
- 15: Bodenquerträger
- 16: Trennwand
- 17: erste Kammer
- 18: zweite Kammer
- 19: erste Luftdurchtrittsöffnungen
- 20: Mischklappe
- 21: Rack
- 22: Profilrahmen
- 23: Bodenlängsträger
- 24: Heizkonvektor
- 25: stirnseitige Außenwand

- 101: Modul eines Rechenzentrums
- 102: Server

- 201: zweites Rechenzentrum
- 202: Server
- 203: Datenleitung

## Patentansprüche

1. Modul (1) für ein Rechenzentrum (101), aufweisend einen temperierbaren Innenraum (10) und einen Luftleitraum (6), wobei in dem Innenraum (10) ein Rack (21) angeordnet ist, das einen ersten Raumbereich (13) von einem zweiten Raumbereich (14) trennt, wobei der Luftleitraum (6) eine erste Kammer (17) und eine zweite Kammer (18) aufweist, wobei
- erste Luftdurchtrittsöffnungen (19) einen Luftdurchtritt zwischen dem ersten Raumbereich (13) und der ersten Kammer (17) und zwischen dem zweiten Raumbereich (14) und der zweiten Kammer (18) ermöglichen,
- zweite, verschließbare Luftdurchtrittsöffnungen (20) im geöffneten Zustand einen Luftdurchtritt zwischen der ersten Kammer (17) und der zweiten Kammer (18) ermöglichen,
- dritte, verschließbare Luftdurchtrittsöffnungen (8a) im geöffneten Zustand einen Luftdurchtritt zwischen der ersten Kammer (17) und der Umgebung ermöglichen, und
- vierte, verschließbare Luftdurchtrittsöffnungen (8b) im geöffneten Zustand einen Luftdurchtritt zwischen der zweiten Kammer (18) und der Umgebung ermöglichen,
wobei das Modul (1) eine Wandung aufweist, die den Innenraum (10) von dem Luftleitraum (6) trennt, wobei die Wandung der Boden (5) oder die Decke des Innenraumes (10) ist und in der Wandung die ersten Luftdurchtrittsöffnungen (19) ausgebildet sind; und wobei der Luftleitraum (6) eine Trennwand (16) aufweist, die den Luftleitraum (6) in die erste Kammer (17) und die zweite Kammer (18) teilt und in der Trennwand (16) die zweiten, verschließbaren Luftdurchtrittsöffnungen (20) ausgebildet sind; und wobei die dritten, verschließbaren Luftdurchtrittsöffnungen (8a) in einer Außenwand (7a) der ersten Kammer (17) ausgebildet sind und die vierten, verschließbaren Luftdurchtrittsöffnungen (8b) in einer Außenwand (7b) der zweiten Kammer (18) ausgebildet sind; und wobei
der Innenraum (10) von einem Container (2) gebildet ist, wobei der Container (2) eine Wandung aufweist, an der der Luftleitraum (6) angebracht ist, wobei in der Wandung des Containers (2) zumindest im Bereich des ersten Raumbereiches (13) und des zweiten Raumbereiches (14) die ersten Luftdurchtrittsöffnungen (19) ausgebildet sind.

2. Modul nach Anspruch 1, **dadurch gekennzeichnet, dass** die Wandung der Boden (5) oder die Decke (12) des Containers (2) ist.

3. Modul nach einem der vorstehenden Ansprüche, **dadurch gekennzeichnet, dass** die erste Kammer (17) an den ersten Raumbereich (13) und die zweite Kammer (18) an den zweiten Raumbereich (14) angrenzt.

4. Modul nach einem der vorstehenden Ansprüche, **dadurch gekennzeichnet, dass** die dritten, verschließbaren Luftdurchtrittsöffnungen (8a) im geöffneten Zustand einen Eintritt von Außenluft in die erste Kammer (17) ermöglichen.

5. Modul nach einem der vorstehenden Ansprüche, **dadurch gekennzeichnet, dass** die vierten, verschließbaren Luftdurchtrittsöffnungen (8b) im geöffneten Zustand einen Austritt von Luft aus der zweiten Kammer (18) in die Umgebung ermöglichen.

6. Modul nach einem der vorstehenden Ansprüche, **dadurch gekennzeichnet, dass** die verschließbaren Luftdurchtrittsöffnungen (8a, 8b, 20) mittels Klappen und/oder Schiebern realisiert sind.

7. Modul nach einem der vorstehenden Ansprüche, **dadurch gekennzeichnet, dass** in dem ersten Raumbereich (13) zumindest eine Heizeinrichtung (24) angeordnet ist.

8. Modul nach einem der vorstehenden Ansprüche, **dadurch gekennzeichnet, dass** es eine Steuereinrichtung zur Steuerung des Öffnens und/oder Verschließens der verschließbaren Luftdurchtrittsöffnungen (8a, 8b, 20) aufweist.

9. Rechenzentrum, aufweisend ein oder mehrere Module gemäß einem der Ansprüche 1 bis 8, **dadurch gekennzeichnet, dass** in dem Rack (21) eines Moduls (1) elektronische Komponenten (102) angeordnet sind, die jeweils zumindest einen Lüfter aufweisen.

10. Rechenzentrum nach Anspruch 9, **dadurch gekennzeichnet, dass** die elektronischen Komponenten (102) Server sind.

11. Verfahren zur Temperierung eines Rechenzentrums gemaß Anspruch 9 oder Anspruch 10, wobei mittels der verschließbaren Luftdurchtrittsöffnungen (8a, 8b, 20) die Temperatur im Innenraum (10) eines Moduls eingestellt wird.

12. Verfahren nach Anspruch 11, **dadurch gekennzeichnet, dass**, wenn die Innentemperatur in dem Innenraum (10) eines Moduls (1) unterhalb einer vorgegebenen Betriebstemperatur liegt, die zweiten Luftdurchtrittsöffnungen (20) geöffnet und die dritten und vierten Luftdurchtrittsöffnungen (8a, 8b) geschlossen sind, so dass mittels der Lüfter der elektronischen Komponenten (102) Luft zwischen dem Innenraum (10) und dem Luftleitraum (6) in einem Kreislauf geführt werden kann.

13. Verfahren nach Anspruch 11 oder Anspruch 12, **dadurch gekennzeichnet, dass**, wenn die Innentemperatur in dem Innenraum (10) eines Moduls (1) bei oder oberhalb einer vorgegebenen Betriebstemperatur liegt, die zweiten Luftdurchtrittsöffnungen (20) geschlossen und die dritten und vierten Luftdurchtrittsöffnungen (8a, 8b) geöffnet sind, so dass mittels der Lüfter der elektronischen Komponenten (102) Luft über die dritten Luftdurchtrittsöffnungen (8a) aus der Umgebung in die erste Kammer (17) eingesaugt wird, von dort über den Kaltgang (13) und den Warmgang (14) in die zweite Kammer (18) gelangt und aus der zweiten Kammer (18) über die vierten Luftdurchtrittsöffnungen (8b) an die Umgebung abgegeben wird.

14. Verfahren nach einem der Ansprüche 11 bis 13, **dadurch gekennzeichnet, dass** die zweiten, dritten und vierten Luftdurchtrittsöffnungen (8a, 8b, 20) geöffnet werden, so dass mittels der Lüfter der elektronischen Komponenten (102) Luft über die dritten Luftdurchtrittsöffnungen (8a) aus der Umgebung in die erste Kammer (17) eingesaugt wird, von dort über den Kaltgang (13) und den Warmgang (14) in die zweite Kammer (18) gelangt und aus der zweiten Kammer (18) zu einem Teil über die vierten Luftdurchtrittsöffnungen (8b) an die Umgebung abgegeben und zu einem anderen Teil im Kreislauf zurück in die erste Kammer (17) geführt wird.

## Claims

1. A module (1) for a computing center (101) having a temperable interior (10) and an air conduction space (6), wherein in a rack (21) is disposed in the interior (10) that separates a first space zone (13) from a second space zone (14), wherein the air conduction space (6) has a first chamber (17) and a second chamber (18), wherein
- first air passage openings (19) permit an air passage between the first space zone (13) and the first chamber (17) and between the second space zone (14) and the second chamber (18),
- second closable air passage openings (20) in the open state permit an air passage between the first chamber (17) and the second chamber (18),
- third closable air passage openings (8a) in the open state permit an air passage between the first chamber (17) and the environment, and
- fourth closable air passage openings (8b) in the open state permit an air passage between the second chamber (18) and the environment,
wherein the module (1) has a wall separating the interior (10) from the air conduction space (6), wherein the wall is the bottom (5) or the ceiling of the interior (10) and the first air passage openings (19) are formed in the wall; and wherein the air conduction space (6) has a separating wall (16) dividing the air conduction space (6) in the first chamber (17) and the second chamber (18) and the second closable air passage openings (20) are formed in the separating wall (16); and wherein the third closable air passage openings (8a) are formed in an outer wall (7a) of the first chamber (17) and the fourth closable air passage openings (8b) are formed in an outer wall (7b) of the second chamber (18); and wherein
the interior (10) is formed by a container (2), wherein the container (2) has a wall to which the air conduction space (6) is attached, wherein the first air passage openings (19) are formed in the wall of the container (2) at least in the region of the first space zone (13) and the second space zone (14).

2. The module according to claim 1, **characterized in that** the wall is the bottom (5) or the ceiling (12) of the container (2).

3. The module according to any of the preceding claims, **characterized in that** the first chamber (17) is adjacent to the first space zone (13) and the second chamber (18) is adjacent to the second space zone (14).

4. The module according to any of the preceding claims, **characterized in that** the third closable air passage openings (8a) in the open state permit an entry of external air into the first chamber (17).

5. The module according to any of the preceding claims, **characterized in that** the fourth closable air passage openings (8b) in the open state permit an exit of air from the second chamber (18) to the environment.

6. The module according to any of the preceding claims, **characterized in that** the closable air passage openings (8a, 8b, 20) are realized by means of flaps and/or sliders.

7. The module according to any of the preceding claims, **characterized in that** at least one heating device (24) is disposed in the first space zone (13).

8. The module according to any of the preceding claims, **characterized in that** it has a control device for controlling the opening and/or closing of the closable air passage openings (8a, 8b, 20).

9. A computing center having one or more modules according to any of claims 1 to 8, **characterized in that** electronic components (102) each having at least one fan are disposed in the rack (21) of one module (1).

10. The computing center according to claim 9, **characterized in that** the electronic components (102) are servers.

11. A method for tempering a computing center according to claim 9 or claim 10, wherein the temperature in the interior (10) of a module is adjusted by means of the closable air passage openings (8a, 8b, 20).

12. The method according to claim 11, **characterized in that** when the internal temperature in the interior (10) of a module (1) is below a given operation temperature the second air passage openings (20) are opened and the third and fourth air passage openings (8a, 8b) are closed, so that air can be passed in a circulation between the interior (10) and the air conduction space (6) by means of the fan of the electronic components (102).

13. The method according to claim 11 or claim 12, **characterized in that** when the internal temperature in the interior (10) of a module (1) is at or above a given operation temperature the second air passage openings (20) are closed and the third and fourth air passage openings (8a, 8b) are opened, so that air is suck up into the first chamber (17) from the environment via the third air passage openings (8a) by means of the fan of the electronic components (102), from there reach the second chamber (18) via the cold corridor (13) and the hot corridor (14) and is released to the environment from the second chamber (18) via the fourth air passage openings (8b).

14. The method according to any of claims 11 to 13, **characterized in that** the second, third, and fourth air passage openings (8a, 8b, 20) are opened, so that air is suck up into the first chamber (17) from the environment via the third air passage openings (8a) by means of the fans of the electronic components (102), from there reach the second chamber (18) via the cold corridor (13) and the hot corridor (14) and to one part is released to the environment from the second chamber (18) via the fourth air passage openings (8b) and to another part is passed back into the first chamber (17) in circulation.

## Revendications

1. Module (1) pour un centre de données (101), comprenant un espace intérieur tempéré (10) et un espace de conduite d'air (6), dans l'espace intérieur (10) se trouvant une baie (21) qui sépare une première zone (13) d'une deuxième zone (14), l'espace de conduite d'air (6) présentant une première chambre (17) et une deuxième chambre (18),
- des premiers orifices de passage d'air (19) permettant un passage d'air entre la première zone (13) et la première chambre (17) et entre la deuxième zone (14) et la deuxième chambre (18),
- des deuxièmes orifices de passage d'air (20) refermables permettant en position ouverte un passage d'air entre la première chambre (17) et la deuxième chambre (18),
- des troisièmes orifices de passage d'air (8a) refermables permettant en position ouverte un passage d'air entre la première chambre (17) et l'environnement, et
- des quatrièmes orifices de passage d'air (8b) refermables permettant en position ouverte un passage d'air entre la deuxième chambre (18) et l'environnement,
le module (1) présentant une cloison qui sépare l'espace intérieur (10) de l'espace de conduite d'air (6), ladite cloison étant le sol (5) ou le plafond de l'espace intérieur (10), et les premiers orifices de passage d'air (19) étant pratiqués dans ladite cloison ; et l'espace de conduite d'air (6) présentant une cloison (16) qui sépare l'espace de conduite d'air (6) entre la première chambre (17) et la deuxième chambre (18) et les deuxièmes orifices de passage d'air (20) refermables étant pratiqués dans la cloison (16) ; et les troisièmes orifices de passage d'air (8a) refermables étant pratiqués dans une cloison extérieure (7a) de la première chambre (17) et les quatrièmes orifices de passage d'air (8b) refermables étant pratiqués dans une cloison extérieure (7b) de la deuxième chambre (18) ; et
l'espace intérieur (10) étant formé par un conteneur (2), ledit conteneur (2) présentant une cloison sur laquelle est appliqué l'espace de conduite d'air (6), les premières orifices de passage d'air (19) étant pratiqués dans la cloison du conteneur (2) au moins dans le domaine de la première zone (13) et de la deuxième zone (14).

2. Module selon la revendication 1, **caractérisé par le fait que** la cloison est le sol (5) ou le plafond (12) du conteneur (2).

3. Module selon une des revendications précédentes, **caractérisé par le fait que** la première chambre (17) est contiguë à la première zone (13) et la deuxième chambre (18) à la deuxième zone (14).

4. Module selon une des revendications précédentes, **caractérisé par le fait que** les troisièmes orifices de passage d'air (8a) refermables permettent en position ouverte une entrée d'air extérieur dans la première chambre (17).

5. Module selon une des revendications précédentes, **caractérisé par le fait que** les quatrièmes orifices de passage d'air (8b) refermables permettent en position ouverte une sortie d'air de la deuxième chambre (18) dans l'environnement.

6. Module selon une des revendications précédentes, **caractérisé par le fait que** les orifices de passage d'air (8a, 8b, 20) sont réalisés au moyen de clapets et/ou de volets coulissants.

7. Module selon une des revendications précédentes, **caractérisé par le fait qu'**au moins une installation de chauffage (24) est prévue dans la première zone (13).

8. Module selon une des revendications précédentes, **caractérisé par le fait qu'**il présente une installation de commande pour commander l'ouverture et/ou la fermeture des orifices de passage d'air (8a, 8b, 20).

9. Centre de données présentant un ou plusieurs modules selon une des revendications 1 à 8, **caractérisé par le fait que** dans la baie (21) d'un module (1) sont prévus des composants électroniques (102) qui possèdent chacun au moins un ventilateur.

10. Centre de données selon la revendication 9, **caractérisé par le fait que** les composants électroniques (102) sont des serveurs.

11. Procédé pour l'équilibrage de température d'un centre de données selon la revendication 9 ou la revendication 10, la température dans l'espace intérieur (10) d'un module étant régulée au moyen d'orifices de passage d'air (8a, 8b, 20) refermables.

12. Procédé selon la revendication 11, **caractérisé par le fait que**, lorsque la température intérieure dans l'espace intérieur (10) d'un module (1) est inférieure à la température de service prédéfinie, les deuxièmes orifices de passage d'air (20) sont ouverts et les troisièmes et quatrièmes orifices de passage d'air (8a, 8b) sont fermés, de sorte que, au moyen des ventilateurs des composants électroniques (102), de l'air soit pulsé en circuit fermé entre l'espace intérieur (10) et l'espace de conduite d'air (6).

13. Procédé selon la revendication 11 ou la revendication 12, **caractérisé par le fait que**, lorsque la température intérieure dans l'espace intérieur (10) d'un module (1) est égale ou supérieure à la température de service prédéfinie, les deuxièmes orifices de passage d'air (20) sont fermés et les troisièmes et quatrièmes orifices de passage d'air (8a, 8b) sont ouverts, de sorte que, au moyen des ventilateurs des composants électroniques (102), de l'air soit aspiré de l'environnement à travers les orifices de passage d'air (8a) vers la première chambre (17), que de là il parvienne dans la deuxième chambre (18) par le passage froid (13) et le passage chaud (14), et dans la deuxième chambre (18) soit redonné à l'environnement par les quatrièmes orifices de passage d'air (8b).

14. Procédé selon une des revendications 11 à 13, **caractérisé par le fait que** les deuxièmes, troisièmes et quatrièmes orifices de passage d'air (8a, 8b, 20) soient ouverts de sorte que, au moyen des ventilateurs des composants électroniques (102), de l'air de l'environnement soit aspiré à travers les troisièmes orifices de passage d'air (8a) vers la première chambre (17), que de là il parvienne dans la deuxième chambre (18) par le passage froid (13) et le passage chaud (14), et de la deuxième chambre (18) il soit en partie rejeté dans l'environnement à travers les quatrièmes orifices de passage d'air (8b) et en partie reconduit en circuit fermé dans la première chambre (17).
